# EUROPÄISCHE PATENTANMELDUNG

(11) **EP 1 653 622 A1**
(43) Veröffentlichungstag der Anmeldung: **03.05.2006**
(21) Anmeldenummer: 05018725.1
(22) Anmeldetag: 29.08.2005
(51) Int. Cl.: H03K 19/0185

(54) **Schaltungsanordnung zur Pegelverschiebung**

(30) Priorität: 26.10.2004 DE 102004052092
(71) Anmelder: Micronas GmbH, 79108 Freiburg i. Br. (DE)
(72) Erfinder: Czech, Martin, 79117 Freiburg (DE)
(74) Vertreter: Patentanwälte Westphal, Mussgnug & Partner

(57) **Zusammenfassung**

Die Erfindung bezieht sich auf eine Schaltungsanordnung zur Pegelverschiebung mit einem ersten und einem zweiten Transistor (A, B), an denen jeweils ein Signal anlegbar ist, und mit einem dritten und einem vierten Transistor (C, D), wobei der erste und der dritte Transistor (A, C) zwischen einer Grundspannung (XUSS) und einer Versorgungsspannung (XUDD) geschaltet sind und zwischen sich einen ersten Verbindungspunkt (O1) aufweisen und wobei der zweite und der vierte Transistor (B, D) zwischen der Grundspannung (XUSS) und der Versorgungsspannung (XUDD) geschaltet sind und zwischen sich einen zweiten Verbindungspunkt (02) aufweisen und wobei der erste Verbindungspunkt (O1) zum Anlegen eines Steuersignals an den vierten Transistor (D) an dessen Steueranschluss und der zweite Verbindungspunkt (02) zum Anlegen eines Steuersignals an den dritten Transistor (C) an dessen Steueranschluss verbunden ist. Die Schaltungsanordnung ist gekennzeichnet durch zumindest eine Verstärkungsschaltung (V) zum Verstärken zumindest eines dieser Steuersignale.

## Beschreibung

Die Erfindung bezieht sich auf eine Schaltungsanordnung zur Pegelverschiebung mit den oberbegrifflichen Merkmalen des Patentanspruchs 1.

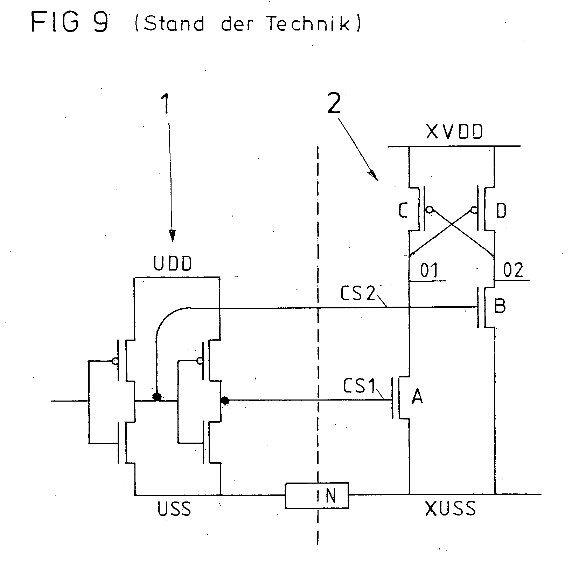

Eine allgemein bekannte Schaltungsanordnung zur Pegelverschiebung ist in Fig. 9 dargestellt. Die Schaltungsanordnung weist zwei Abschnitte mit jeweils eigener Betriebsspannung auf, wobei der linksseitige, erste Abschnitt 1 ein Spannungssystem zwischen einer Masse bzw. Grundspannung USS und einer Versorgungsspannung UDD aufweist. Der rechtsseitige, zweite Abschnitt 2 weist eine zweite Betriebsspannung zwischen einer Masse bzw. Grundspannung XUSS und einer Versorgungsspannung XUDD auf. Zwischen diesen Betriebsspannungen sind jeweils Komponenten angeordnet.

Im ersten Abschnitt 1 wird ein Steuersignal angelegt und mittels Invertern oder anderen MOS-Schaltungsanordnungen (MOS: Metal Oxide Semiconductor) verarbeitet. Der erste Abschnitt 1 liefert somit in für sich bekannter Art und Weise Signale über zwei Leitungen bzw. Verbindungen CS1, CS2 zu der eigentlichen Schaltungsanordnung zur Pegelverschiebung, welche durch den zweiten Abschnitt 2 und weitere nicht dargestellte Komponenten ausgebildet wird. Die über die Verbindungen CS1, CS2 gelieferten Signale beruhen somit auf einem Abschnitt 1 der Schaltungsanordnung mit der Betriebsspannung UDD-USS zwischen der ersten Grundspannung USS und der Versorgungsspannung UDD. Diese Signale werden an den zweiten Abschnitt 2 geliefert, dessen Komponenten mit einer Betriebsspannung XUDD-XUSS zwischen der zweiten Grundspannung XUSS und der zweiten Versorgungsspannung XUDD betrieben werden. Optional sind die beiden Grundspannungen USS und XUSS der beiden Abschnitte 1, 2 miteinander gekoppelt, beispielsweise durch die skizzierte Vorrichtung N, welche oftmals nur durch eine Leitung ausgebildet wird, welche die beiden Grundspannungen USS, XUSS kurzschließt. Es kann sich bei der Vorrichtung N aber z. B. auch um einen Widerstand, Dioden, Biopolartransistoren oder MOS- Transistoren sowie aus Kombinationen daraus handeln. Die in Fig. 9 dargestellte Pegelverschiebungsschaltung verfolgt den Zweck, ein einheitliches Referenzpotenzial für die ganze Schaltungsanordnung mit dem ersten und dem zweiten Abschnitt A, B bereitzustellen.

Der zweite Abschnitt 2 umfasst die wesentlichen Komponenten einer typischen Pegelschieberschaltung. Zwischen der Grundspannung XUSS und der Versorgungsspannung XUDD des zweiten Abschnitts 2 sind zwei Transistoren, ein erster Transistor A und ein dritter Transistor C hintereinander geschaltet. Zwischen dem ersten und dem dritten Transistor A, C ist ein erster Verbindungspunkt O1 zum Bereitstellen eines den von der linken Seite eingegebenen Signalen entsprechenden ersten Signals 01 ausgebildet. Außerdem ist zwischen die Grundspannung XUSS und die Versorgungsspannung XUDD ein zweiter Transistor B und ein vierter Transistor D mit einem zweiten Verbindungspunkt 02 zwischen den beiden Transistoren B, D geschaltet. Der zweite Verbindungspunkt 02 dient entsprechend dem ersten Verbindungspunkt 01 zum Bereitstellen eines Signals, insbesondere Informationssignals für weitere Komponenten und/oder Schaltungsabschnitte des zweiten Abschnitts 2. An die Basis bzw. die Steueranschlüsse des ersten und des dritten Transistors A, B sind die erste und die zweite Verbindung CS1, CS2 zum Übertragen von Signalen aus dem ersten Abschnitt 1 angeschlossen. Von dem ersten Verbindungspunkt 01 aus führt außerdem eine Verbindung zum Steueranschluss des vierten Transistors D. Vom zweiten Verbindungspunkt 02 aus führt eine entsprechende Verbindung zum Steueranschluss des dritten Transistors C. Typischerweise umfasst eine solche Schaltungsanordnung weitere Bauelemente wie Dioden, welche teils auch als parasitäre Komponenten beim Schaltungsentwurf mit berücksichtigt werden.

Der erste und der zweite Transistor A, B, welche vorzugsweise als NMOS-Transistoren (NMOS: n-Kanal-Metal-Oxide-Semiconductor(p-Metalloxidhalbleiter)) ausgebildet sind, im werden durch die Signale bzw. Spannungspotentiale auf den Verbindungen CS1 bzw. CS2 derart angesteuert, dass einer sperrend wird und der andere entsprechend leitend. Der erste und der zweite Transistor A, B sind so dimensioniert, dass sie in jedem Fall die Knoten bzw. Verbindungspunkte O1, 02 gegen den an der Versorgungsspannung XUDD hängenden dritten bzw. vierten Transistor C, D so weit herunterziehen können, dass der dazu gegenüberliegende vierte bzw. dritte Transistor D, C dadurch aufgesteuert wird und den gegenüberliegenden Verbindungspunkt 02 bzw. 01 entsprechend heraufzieht. Dies schaltet schließlich den einen "Widerstand" ausübenden dritten bzw. vierten Transistor C, D ab. Der dritte und der vierte Transistor C, D sind beispielsweise als PMOS-Transistoren (PMOS: p-Kanal-MOS) ausgebildet. Der dritte und der vierte Transistor C, D haben also eine Rückkopplungswirkung, wodurch die Pegelschieberschaltung schließlich in einen neuen Zustand kippt, in welchem die beiden Verbindungspunkte 01, 02 das Potenzial der Versorgungsspannung XUDD oder der Grundspannung XUSS annehmen bzw. umgekehrt annehmen. Angenommen werden somit volle Pegel entsprechend der Ansteuerung des ersten und des zweiten Transistors A, B. Durch die Stromansteuerung des dritten und des vierten Transistors C, D durch den ersten bzw. den zweiten Transistor A bzw. D und die Rückkopplung ist es daher möglich, aus einer Schaltung, d. h. dem ersten Abschnitt 1 mit kleiner Versorgungsspannung UDD gegenüber der Grundspannung USS einen vollen Hub der größeren Betriebsspannung zwischen der dortigen Grundspannung XUSS und der Versorgungsspannung XUDD auf der Seite des zweiten Abschnitts hervorzubringen.

Eine solche als Pegelschieber (Level-Shifter) bezeichnete Schaltung wird insbesondere in CMOS-Schaltungen (CMOS: Complementary Metal Oxide Semiconductor) wichtig, da Signale auch auf der hohen Betriebsspannungsseite vollen Hub haben müssen, um Querströme vermeiden zu können. Die Transistoren im ersten Abschnitt 1 sind üblicherweise gemäß einer anderen Technologieoption gefertigt als die Transistoren A - D im zweiten Abschnitt 2. Letztere dürfen mit der hohen Spannung arbeiten, haben also eine hohe Schwellspannung, eine hohe Abbruchspannung und ein entsprechend dick ausgebildetes Oxid. Hingegen dürfen die Transistoren auf der Seite des ersten Abschnitts 1 auf keinen Fall mit der hohen Spannung betrieben werden, da sie ausgebildet sind für einen früheren Abbruch, eine niedrigere Schwellspannung sowie mit einem dünnen Oxid.

Eine solche Schaltungsanordnung hat den für die XMOS-Schaltungstechnik eigentlich untypischen Nachteil, dass der erste und der zweite Transistor A, B zunächst bei einem Schaltvorgang gegen den zunächst voll aufgesteuerten dritten bzw. vierten Transistor C, D ankämpfen müssen, um dadurch die Pegel an den Verbindungspunkten 01 bzw. 02 niederzuzwingen. Dadurch fließen nicht nur Querströme, sondern es bestehen außerdem Einschränkungen für die Dimensionierung der Transistoren A - D. Der erste und zweite Transistor A, B müssen so stark dimensioniert sein, dass selbst im ungünstigsten Fall, d. h. bei niedriger Versorgungsspannung im ersten Abschnitt 1 und hoher Versorgungsspannung XUDD im zweiten Abschnitt 2, hohen Umgebungstemperaturen und einer entsprechenden Prozesslage, die Verbindungspunkte O1, 02 niedrig genug kommen, um die Rückkopplungswirkung auszulösen. Entsprechend müssen der dritte und der vierte Transistor C, D entsprechend schwach dimensioniert sein. Die Schaltung trägt also eine CMOS-untypische Asymmetrie zwischen NMOS-Transistoren und PMOS-Transistoren in sich. Dies führt zu einem großen Flächenbedarf bei dem Design einer entsprechenden Schaltung und benötigt außerdem mehr Durchlaufzeit als z. B. in einem Inverter der gleichen Technologie. Die Schaltung ist daher auch nicht gut zum Treiben größerer Lasten geeignet, da sich dann die Asymmetrie in stark abweichenden Anstiegs- und Abfallzeiten äußert. Besonders deutlich und schädlich wird die Asymmetrie, wenn die Betriebsspannung UDD-USS im ersten Abschnitt 1 immer kleiner gegenüber der Betriebsspannung XUDD-XUSS des zweiten Abschnitts 2 wird.

Dadurch werden dann der erste und der zweite Transistor A, B kaum noch ausgesteuert, was nur sehr kleine Ströme zulässt. In der Folge müssen der dritte und der vierte Transistor C, D sehr schwach ausgelegt werden, was ein nicht mehr tolerierbares Zeitverhalten der Schaltung zur Folge hat.

Die schwach dimensioniert konstruierten Transistoren C, D lassen außerdem die Ausgangsknoten bzw. die beiden Verbindungspunkte 01, 02 empfindlich gegenüber Einstreuungen werden. Der erste und der zweite Transistor A, B müssen daher sehr stark ausgelegt werden, was zum Teil absurde Transistorgrößen erforderlich macht. Bei einem sehr großen Unterschied zwischen der Betriebsspannung UDD-USS des ersten Abschnitts 1 und der Betriebsspannung XUDD-XUSS des zweiten Abschnitts 2 kann es außerdem passieren, dass eine Schaltung für sich bekannter Bauart unter keinen Umständen mehr funktioniert. Dies ist insbesondere mit Blick auf die fortschreitende Verkleinerung bzw. geringere Dimensionierung der Transistoren ein zunehmendes Problem.

Die Aufgabe der Erfindung besteht darin, eine Schaltungsanordnung zur Pegelverschiebung mit verbesserter Bauweise und Funktionalität vorzuschlagen.

Diese Aufgabe wird durch die Schaltungsanordnung zur Pegelverschiebung gemäß den Merkmalen des Patentanspruchs 1 gelöst.

Bevorzugt wird eine Schaltungsanordnung zur Pegelverschiebung mit einem ersten und einem zweiten Transistor, an denen jeweils ein Signal anlegbar ist, und mit einem dritten und einem vierten Transistor, wobei der erste und der dritte Transistor zwischen einer Grundspannung und einer Versorgungsspannung geschaltet sind und zwischen sich einen ersten Verbindungspunkt aufweisen und wobei der zweite und der vierte Transistor zwischen der Grundspannung und der Versorgungsspannung geschaltet sind und zwischen sich einen zweiten Verbindungspunkt aufweisen und wobei der erste Verbindungspunkt zum Anlegen eines Steuersignals an den vierten Transistor an dessen Steueranschluss und der zweite Verbindungspunkt zum Anlegen eines Steuersignals an den dritten Transistor an dessen Steueranschluss verbunden ist. Die Schaltungsanordnung weist zumindest eine Verstärkerschaltung zum Verstärken zumindest eines dieser Steuersignale auf.

Vorteilhafte Ausgestaltungen sind Gegenstand von abhängigen Ansprüchen.

Bevorzugt wird insbesondere eine Schaltungsanordnung, bei der die Verstärkerschaltung zumindest einen Verstärker aufweist, der zwischen einen der Verbindungspunkte und den Steueranschluss des dazu zugeordneten Transistors geschaltet ist.

Bevorzugt wird insbesondere eine Schaltungsanordnung, bei der die Verstärkerschaltung zumindest einen Impulsformer und/oder Impulsgeber aufweist, der zwischen einen der Verbindungspunkte und den Steueranschluss des dazu zugeordneten Transistors geschaltet ist.

Bevorzugt wird insbesondere eine Schaltungsanordnung, bei der die Verstärkerschaltung zumindest einen Verstärker und zusätzlich zumindest einen Impulsformer und/oder Impulsgeber aufweist, wobei der Verstärker zwischen einen der Verbindungspunkte und den Steueranschluss des dazu zugeordneten vierten oder dritten Transistors geschaltet ist und wobei der Impulsformer und/oder Impulsgeber zwischen diesen der Verbindungspunkte und einen weiteren, fünften oder sechsten Transistor geschaltet ist, wobei der weitere Transistor parallel zu dem vierten bzw. dritten Transistor geschaltet ist, der über den Verstärker vom selben Verbindungspunkt angesteuert wird.

Bevorzugt wird insbesondere eine Schaltungsanordnung, bei welcher der Impulsformer und/oder Impulsgeber dem Verstärker nachgeschaltet ist und ein verstärktes Steuersignal vom Verstärker empfängt.

Bevorzugt wird insbesondere eine Schaltungsanordnung, bei der die Verstärkerschaltung einen oder mehrere Transistoren ansteuert, welche parallel zu Transistoren geschaltet sind, welche von dem jeweils selben Verbindungspunkt angesteuert werden.

Bevorzugt wird insbesondere eine Schaltungsanordnung, bei der die Verstärkerschaltung mehrere Eingänge zum Anlegen jeweils eines Steuersignals von einem der Verbindungspunkte und zumindest einen, vorzugsweise mehrere Ausgänge zum Ausgeben verstärkter und/oder geformter Steuersignale zu Steuereingängen des dritten und/oder vierten und/oder weiteren Transistoren aufweist.

Bevorzugt wird insbesondere eine Schaltungsanordnung, bei welcher der erste und der zweite Transistor jeweils einen Steueranschluss aufweisen zum Anlegen jeweils eines Spannungssignals aus einem Spannungssystem mit niedrigerer Spannung als zwischen der Grundspannung und der Versorgungsspannung.

Bevorzugt wird insbesondere eine Schaltungsanordnung, bei der die Verstärkerschaltung zum Ausgeben eines verstärkten und/oder geformten Steuersignals ausgebildet und geschaltet ist.

Bevorzugt wird insbesondere ein Differenzverstärker mit einer Schaltung zum Verstärken eines Differenzsignals und mit einer solchen Verstärkerschaltung.

Bevorzugt wird außerdem ein Verfahren zum Betreiben einer Phasenschieberschaltung oder eines Differenzverstärkers, bei dem Steuersignale über Kreuz gekoppelter Transistoren vor deren Anlegen an einen Steueranschluss des zugeordneten Transistors verstärkt und/oder geformt werden.

Insbesondere bevorzugt wird ein solches Verfahren, bei dem die Steuersignale nur zeitlich begrenzt verstärkt und/oder geformt an den entsprechenden Steueranschluss angelegt werden.

Ein Ausführungsbeispiel sowie Varianten dazu werden nachfolgend anhand der Zeichnung näher erläutert. Es zeigen:
- Fig. 1: eine erste beispielhafte Schaltungsanordnung zur Pegelverschiebung mit einer Verstärkungsanordnung;
- Fig. 2A, 2B: Kennlinien verschiedener Verstärkungselemente beim Einsatz in einer solchen Schaltungsanordnung;
- Fig. 3 - 5, 8: alternative Ausgestaltungen zu der Schaltungsanordnung gemäß Fig. 1;
- Fig. 6, 7: einzelne Schaltungselemente der dargestellten Schaltungsanordnungen; und
- Fig. 9: eine Schaltungsanordnung gemäß dem Stand der Technik.

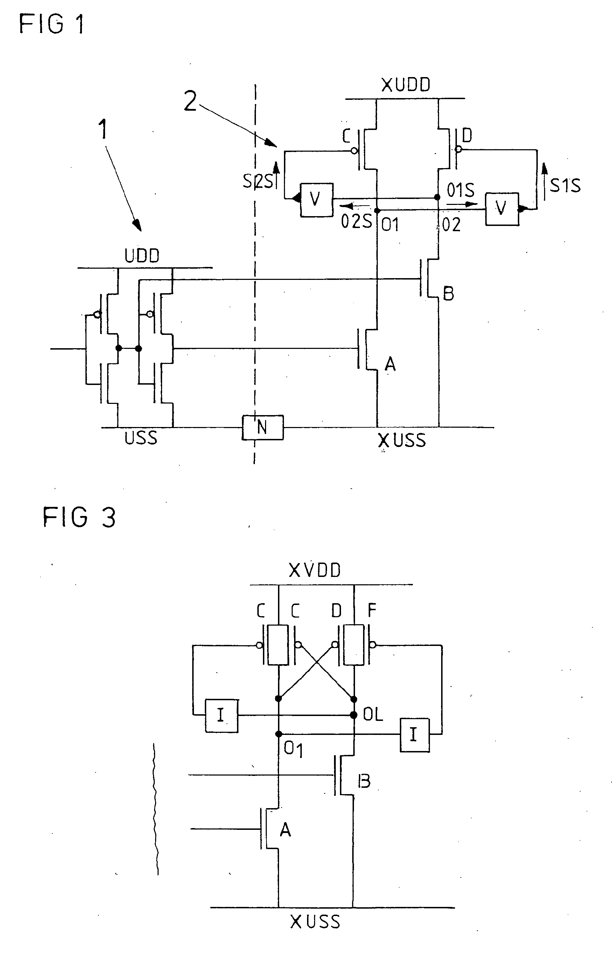

Wie aus Fig. 1 ersichtlich, besteht eine beispielhafte Schaltungsanordnung zur Pegelverschiebung aus zumindest zwei Abschnitten mit jeweils eigener Betriebsspannung, wobei der linksseitige, erste Abschnitt 1 ein Spannungssystem zwischen einer Masse bzw. Grundspannung USS und einer Versorgungsspannung UDD aufweist. Der rechtsseitige, zweite Abschnitt 2 weist eine zweite Betriebsspannung zwischen einer Masse bzw. Grundspannung XUSS und einer Versorgungsspannung XUDD auf. Zwischen diesen Betriebsspannungen sind jeweils Komponenten angeordnet.

Im ersten Abschnitt 1 wird ein Steuersignal angelegt und mittels Invertern oder anderen MOS-Schaltungsanordnungen (MOS: Metal Oxide Semiconductor) verarbeitet. Der erste Abschnitt 1 liefert somit in für sich bekannter Art und Weise Signale über zwei Leitungen bzw. Verbindungen CS1, CS2 zu der eigentlichen Schaltungsanordnung zur Pegelverschiebung, welche durch den zweiten Abschnitt 2 und weitere nicht dargestellte Komponenten ausgebildet wird. Die über die Verbindungen CS1, CS2 gelieferten Signale beruhen somit auf einem Abschnitt 1 der Schaltungsanordnung mit der Betriebsspannung UDD-USS zwischen der ersten Grundspannung USS und der Versorgungsspannung UDD. Diese Signale werden an den zweiten Abschnitt 2 geliefert, dessen Komponenten mit einer Betriebsspannung XUDD-XUSS zwischen der zweiten Grundspannung XUSS und der zweiten Versorgungsspannung XUDD betrieben werden. Für die vorliegenden Betrachtungen zur Verbesserung einer Pegelschieberschaltung sind die Komponenten des ersten Abschnitts 1 nicht von hervorzuhebender Bedeutung und daher lediglich zur Erleichterung des Verständnisses mit Blick auf eine übliche Schaltungsanordnung beschrieben.

Optional sind die beiden Grundspannungen USS und XUSS der beiden Abschnitte 1, 2 miteinander gekoppelt, beispielsweise durch die skizzierte Vorrichtung N, welche auch nur durch eine Leitung ausgebildet werden kann, welche die beiden Grundspannungen USS und XUSS kurzschließt. Es kann sich bei der Vorrichtung N aber z. B. auch um einen Widerstand, Dioden, Biopolartransistoren oder MOS- Transistoren sowie aus Kombinationen daraus handeln. Die in Fig. 1 dargestellte Pegelverschiebungsschaltung verfolgt den Zweck, ein einheitliches Referenzpotenzial für die ganze Schaltungsanordnung mit dem ersten und dem zweiten Abschnitt 1, 2 bereitzustellen.

Der zweite Abschnitt 2 umfasst die wesentlichen Komponenten einer typischen Pegelschieberschaltung. Zwischen der Grundspannung XUSS und der Versorgungsspannung XUDD des zweiten Abschnitts 2 sind zwei Transistoren, ein erster Transistor A und ein dritter Transistor C hintereinander geschaltet. Zwischen dem ersten und dem dritten Transistor A, C ist ein erster Verbindungspunkt O1 zum Bereitstellen eines den von der linken Seite eingegebenen Signalen entsprechenden ersten Signals 01 ausgebildet. Außerdem ist zwischen die Grundspannung XUSS und die Versorgungsspannung XUDD ein zweiter Transistor B und ein vierter Transistor D mit einem zweiten Verbindungspunkt 02 zwischen den beiden Transistoren B, D geschaltet.

Der zweite Verbindungspunkt 02 dient entsprechend dem ersten Verbindungspunkt O1 zum Bereitstellen eines Signals, insbesondere Informationssignals für weitere Komponenten und/oder Schaltungsabschnitte des zweiten Abschnitts 2. An die Basis bzw. die Steueranschlüsse des ersten und des dritten Transistors A, B sind die erste und die zweite Verbindung CS1, CS2 zum Übertragen von Signalen aus dem ersten Abschnitt 1 angeschlossen.

Von dem ersten Verbindungspunkt 01 aus führt außerdem eine Verbindung zum Steueranschluss des vierten Transistors D. In diese Verbindung vom ersten Verbindungspunkt O1 aus zu dem Steueranschluss des vierten Transistors D ist eine Verstärkungsschaltung bzw. eine Komponente einer größer dimensionierten Verstärkungsschaltung zwischengeschaltet. Diese Verstärkungsschaltung bewirkt, dass bereits bei einer geringen Spannungsänderung an dem ersten Verbindungspunkt 01 durch eine geeignete Verstärkung ein verstärktesSteuersignal an dem Steueranschluss des vierten Transistors D angelegt wird, so dass dieser schneller als bei für sich bekannten Schaltungsanordnungen schaltet.

Vom zweiten Verbindungspunkt 02 aus führt eine entsprechende Verbindung über eine entsprechende Verstärkerschaltung oder Verstärkeranordnung zum Steueranschluss des dritten Transistors C. Typischerweise umfasst eine solche Schaltungsanordnung weitere Bauelemente wie Dioden, welche teils auch als parasitäre Komponenten beim Schaltungsentwurf mit berücksichtigt werden.

Der erste und der zweite Transistor A, B, welche vorzugsweise als NMOS-Transistoren ausgebildet sind, werden durch die Signale bzw. Spannungspotentiale auf den Verbindungen CS1 bzw. CS2 derart angesteuert, dass einer sperrend wird und der andere entsprechend leitend. Der erste und der zweite Transistor A, B sind so dimensioniert, dass sie in Verbindung mit den entsprechenden Verstärkerschaltungen V in jedem Fall die Knoten bzw. Verbindungspunkte 01, 02 gegen den an der Versorgungsspannung XUDD hängenden dritten bzw. vierten Transistor C, D so weit herunterziehen können, dass der gegenüberliegende vierte bzw. dritte Transistor D, C dadurch aufgesteuert wird und den gegenüberliegenden Verbindungspunkt 02 bzw. 01 entsprechend heraufzieht. Dies schaltet schließlich den einen "Widerstand" ausübenden dritten bzw. vierten Transistor C, D ab. Der dritte und der vierte Transistor sind beispielsweise als PMOS-Transistoren (PMOS: p-Kanal-MOS) ausgebildet. Der dritte und der vierte Transistor C, D haben also eine Rückkopplungswirkung, wodurch die Pegelschieberschaltung schließlich in einen neuen Zustand kippt, in welchem die beiden Verbindungspunkte O1, 02 das Potenzial der Versorgungsspannung XUDD oder der Grundspannung XUSS annehmen bzw. umgekehrt annehmen. Angenommen werden somit volle Pegel entsprechend der Ansteuerung des ersten und des zweiten Transistors A, B. Durch die Stromansteuerung des dritten und des vierten Transistors C, D durch den ersten bzw. den zweiten Transistor A bzw. D und die Rückkopplung ist es daher möglich, aus einer Schaltung, d. h. dem ersten Abschnitt 1 mit kleiner Versorgungsspannung UDD gegenüber der Grundspannung USS einen vollen Hub der größeren Betriebsspannung zwischen der dortigen Grundspannung XUSS und der Versorgungsspannung XUDD auf der Seite des zweiten Abschnitts hervorzubringen.

Bei den Komponenten der Verstärkungsschaltung handelt es sich gemäß einer einfachen Ausführungsform, wie dies in'Fig. 1 dargestellt ist, um einfache Verstärker V. Es werden somit Verstärker V eingesetzt, welche den Pegel auf den Knoten bzw. Verbindungspunkten 01, 02 beobachten und schon bei geringen Absenkungen ein verstärktes, vorzugsweise ein volles Signal an den zugeordneten vierten bzw. dritten Transistor D, C als Steuersignal anlegen. Vorteilhafterweise müssen daher der erste und der zweite Transistor A, B nicht mehr derart stark dimensioniert ausgebildet werden, wie dies gemäß einer Schaltungsanordnung nach Fig. 9 erforderlich ist. Außerdem müssen die übrigen, d. h. der dritte und der vierte Transistor C, D nicht mehr derart schwach dimensioniert werden, wie diejenigen bei der Schaltungsanordnung gemäß Fig. 9.

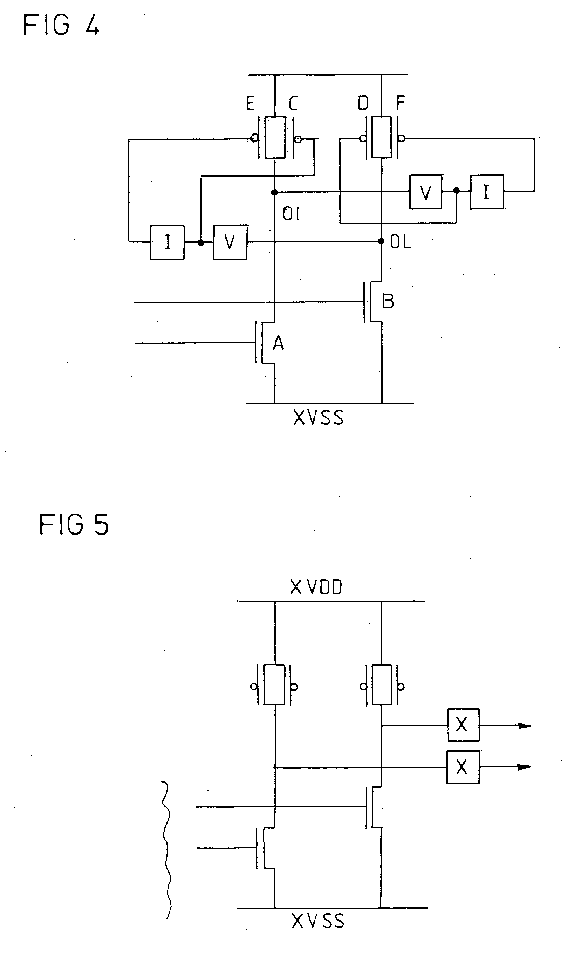

Neben einfachen Verstärkern V als Verstärkerschaltungskomponenten gemäß der Ausführungsform aus Fig. 1 können zusätzlich oder alternativ auch Impulsformer und/oder Impulsgeber als Impulsstufen I eingesetzt werden, wie dies anhand der Schaltungsanordnungen in den Fig. 3 und 4 skizziert ist. Insbesondere können derartige Impulsstufen zum Ansteuern des Steueranschlusses zusätzlicher Transistoren E, F eingesetzt werden, wobei diese zusätzlichen Transistoren E, F vorzugsweise parallel zum dritten bzw. vierten Transistor C, D geschaltet sind. Die Impulsstufen I können die Knoten bzw. Verbindungspunkte 01, 02 besonders rasch nach oben ziehen, wodurch der gesamte Kippvorgang deutlich beschleunigt wird und rasch überall volle Pegel erreicht werden.

Zusätzlich zu den verschiedenen Schaltungsanordnungen der Fig. 1, 3 und 4 können weitere Verstärkerelemente X zwischen den Verbindungspunkten 01, 02 und entsprechenden Signalausgängen geschaltet werden, um den Kern der Schaltung von zu treibenden Schaltungen zu entkoppeln und dadurch Rückwirkungen auf den Kern zu vermeiden.

Fig. 3A zeigt die Kennlinie eines beispielhaften Verstärkers V. Die Verstärker innerhalb einer Schaltungsanordnung sind vorzugsweise, jedoch nicht zwingend mit jeweils gleichen Verstärkungseigenschaften ausgestaltet. Bei der dargestellten Kennlinie handelt es sich um eine nicht-lineare Kennlinie, so dass bereits eine geringfügige Absenkung einer Eingangsspannung 01S am Eingang des Verstärkers V über dessen Ausgangsspannung S1S den angesteuerten Transistor C stark nach unten absenkt, vorzugsweise bis zur Sättigung hin absenkt. Dadurch wird auch bei nur leichtem Absenken der Pegel an den Verbindungspunkten 01, 02 der jeweils gegenüberliegende vierte bzw. dritte Transistor D, C schneller angesteuert, was wiederum über die Rückkopplung den anderen, d. h. dritten bzw. vierten Transistor C, D abschaltet und so das völlige Absenken auf die Grundspannung XUSS ermöglicht oder beschleunigt.

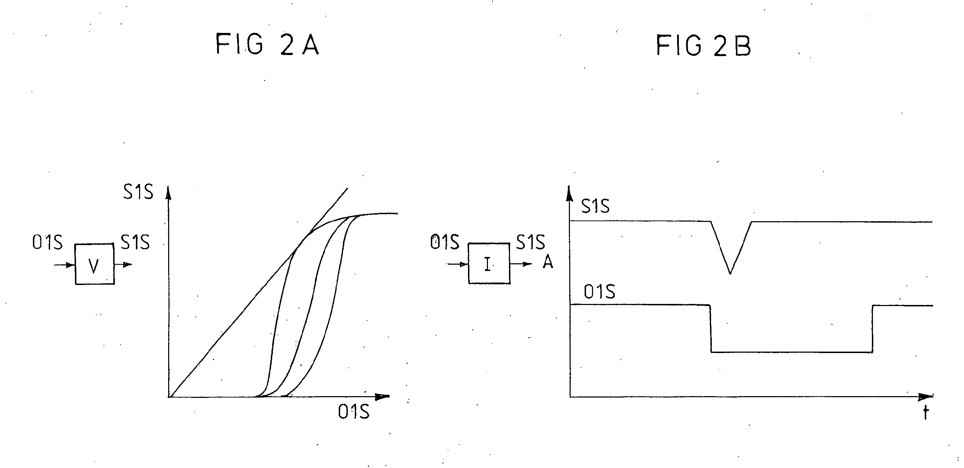

Fig. 2B zeigt die Funktion eines beispielhaften Impulsformers I. Eine beispielsweise fallende Flanke des Signals am Verbindungspunkt 01 und damit am Eingang des Impulsformers I führt zu einem kurzen Impuls an dem Ausgang des Impulsformers I, wobei der Impuls als impulsförmiges Steuersignal S1S an den Steuereingang des zugeordneten Transistors F angelegt wird. Dadurch werden die in Fig. 3 abgebildeten zusätzlichen Transistoren E, F im Moment des Kippens durch den jeweils zugeordneten Impulsformer I aktiv geschaltet, so dass sie kurz aufsteuern. Dadurch erfolgt das Hochziehen des entsprechenden Verbindungspunktes 01, 02 entsprechend schnell.

Fig. 4 zeigt eine besonders bevorzugte Ausführungsform, bei welcher Verstärker V und zusätzlich Impulsformer I zwischen jeden der Verbindungspunkte 01, 02 und entsprechende Transistoren D, F bzw. C, E geschaltet sind. Wie auch bei Fig. 3 sind wiederum nur diejenigen Komponenten beschrieben, welche einen Unterschied zu der Ausführungsform gemäß Fig. 1 darstellen. Bezüglich der weiteren Komponenten wird auf die Beschreibung von Fig. 1 verwiesen. Bei der Schaltungsanordnung gemäß Fig. 4 sorgen die Verstärker V wiederum für ein frühzeitiges Kippen, d. h. insbesondere einen Kipppunkt bei der Gleichspannungsanalyse durch die Verstärkerschaltung. Die nachgeschalteten oder parallel geschalteten Impulsformer I setzten mit den Hilfstransistoren als zusätzlichen Transistoren E, F das Kippen schneller durch.

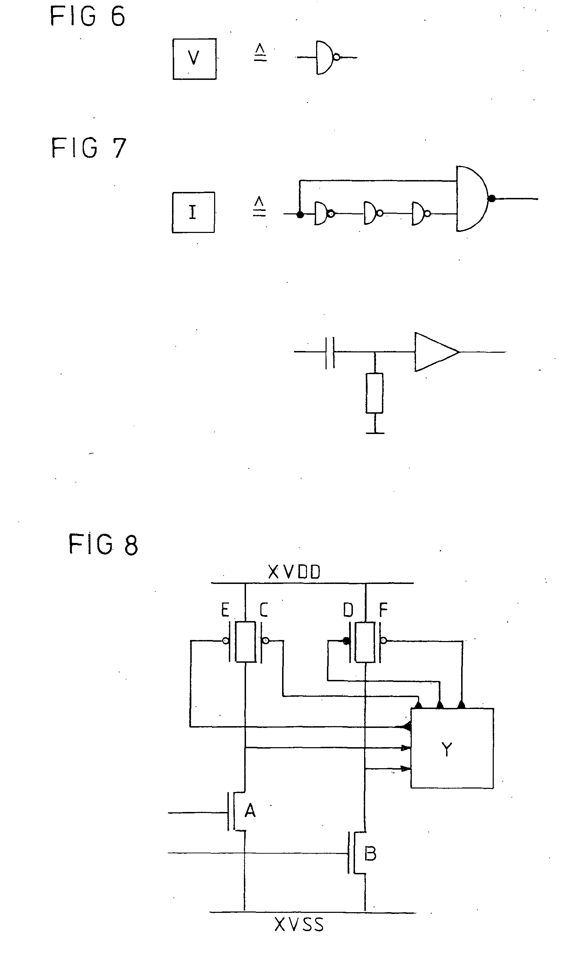

Bei den Schaltungsanordnungen mit den zusätzlichen Transistoren E, F als Hilfstransistoren sollen diese nicht an der herunterziehenden Seite aktiv werden, da dies jede Aktion bremsen oder sogar stoppen könnte. Außerdem sollen die Impulsformer I die gegebenenfalls stark dimensionierten zusätzlichen Transistoren E, F nur für einen kurzen Moment ansteuern, und zwar vorzugsweise im best geeigneten Moment. Wären die zusätzlichen Transistoren E, F immer aktiv, so könnten der erste und der zweite Transistor A, B die zugeordneten Verbindungspunkte 01 bzw. 02 kaum oder gar nicht mehr bewegen, so dass jede Aktion unmöglich werden würde. Vorzugsweise werden die Schaltungsanordnungen gemäß Fig. 1, 3 oder 4 um Auskoppelverstärker als weitere Verstärker X, welche in Fig. 5 skizziert sind, ergänzt. Die weiteren Verstärker X können die Verbindungspunkte 01, 02 von ihren Lasten abschirmen.

Gemäß Fig. 6 können die Verstärker V, X vorteilhafterweise aus einfachen Invertern bestehen. Wie dies in Fig. 7 skizziert ist, können die Impulsformer I aus Inverterketten mit logischen Gattern bestehen, wie sie als digitale Differenzierer für sich genommen bekannt sind. Prinzipiell ist auch eine Schaltungsanordnung als analoger Differenzierer umsetzbar.

Fig. 8 skizziert, dass das vorliegende Konzept als Verstärkeranordnung mit einer beliebigen Verstärkerschaltung Y umsetzbar ist, wobei die Verstärkerschaltung Y das Ziehen des ersten und des zweiten Transistors A, B detektiert und entsprechende Maßnahmen einleitet, um den entsprechend zugeordneten dritten bzw. vierten Transistor C, D sowie gegebenenfalls zusätzlich vorhandene Transistoren E, F derart zu schalten, dass das schlechte Verhalten des für sich bekannten Pegelschieberkerns verbessert wird.

Die beispielhaften Schaltungsanordnungen sowie beliebige weitere Schaltungsanordnungen auf dem Prinzip der Verstärkung des Signals bzw. der Spannung an den Verbindungspunkten 01, 02 lässt sich insbesondere in jeder CMOS-Schaltung anwenden, welche zwei oder mehr verschiedene Betriebsspannungen hat. Besondere Vorteile werden bei Schaltungsanordnungen mit hohen Geschwindigkeitsanforderungen sowie großen Unterschieden der Betriebsspannungen UDD-USS bzw. XUDD-XUSS erzielt. Dies ist beispielsweise bei fortgeschrittenen CMOS-Prozessen der 0,18 µm- oder der 0,13 µm-Klasse der Fall, bei denen die Kernspannung nur 1,8 V oder 1,2 V beträgt, die Eingangs- und/oder Ausgangsspannung aber z. B. 3,3 V.

Die Umsetzung des Konzeptes ist nicht auf digitale Schaltungen begrenzt. Auch analoge Schaltungen benötigen derartige Pegelumsetzer für digitale Steuersignale etc. und können entsprechend aufgebaut werden. Möglich ist die Umsetzung auch zur Beschleunigung von linearen Schaltungen, also z. B. einem Differenzverstärker. Auch DMOS- oder VMOS-Schaltungen können derart mit einem Verstärker bzw. einer Verstärkerschaltung ausgestattet werden. Umsetzbar ist das Konzept auf verschiedenartige Varianten von MOS-Prozessen.

Möglich ist insbesondere die Umkehrung des Substrattyps, wobei alle Transistoren durch ihren Komplementärtyp ersetzt werden. Auch der Einsatz des Konzeptes in NMOS- oder PMOS-Technologien ist möglich.

Neben dem Einsatz in integrierten Schaltungen ist auch der Einsatz in diskreten Schaltungsanordnungen mit Einzeltransistoren oder mit niedrig integrierten Transistorbausteinen möglich. Auch der Einsatz mit bipolaren Transistoren ist möglich, insbesondere möglich, wenn die Verstärkerschaltung Y gemäß Fig. 8 entsprechend ausgelegt wird und die NMOS-Transistoren durch NPN-Strukturen bzw. die PMOS-Transistoren durch PNP-Strukturen ersetzt werden. Die Anordnung der verschiedenen Verstärkungselemente V, I, X können beliebig an dem Kern des Pegelschiebers angeordnet werden, je nach bester Anordnung entsprechend dem konkreten Designlayout.

## Patentansprüche

1. Schaltungsanordnung zur Pegelverschiebung mit
- einem ersten und einem zweiten Transistor (A, B), an denen jeweils ein Signal anlegbar ist, und
- einem dritten und einem vierten Transistor (C, D),
- wobei der erste und der dritte Transistor (A, C) zwischen einer Grundspannung (XUSS) und einer Versorgungsspannung (XUDD) geschaltet sind und zwischen sich einen ersten Verbindungspunkt (01) aufweisen und wobei der zweite und der vierte Transistor (B, D) zwischen der Grundspannung (XUSS) und der Versorgungsspannung (XUUD) geschaltet sind und zwischen sich einen zweiten Verbindungspunkt (02) aufweisen und
- wobei der erste Verbindungspunkt (01) zum Anlegen eines Steuersignals an den vierten Transistor (D) an dessen Steueranschluss und der zweite Verbindungspunkt (02) zum Anlegen eines Steuersignals an den dritten Transistor (C) an dessen Steueranschluss verbunden ist,
**gekennzeichnet durch**
- zumindest eine Verstärkerschaltung (V; I; V, I; Y) zum Verstärken zumindest eines dieser Steuersignale.

2. Schaltungsanordnung nach Anspruch 1, bei der die Verstärkerschaltung zumindest einen Verstärker (V) aufweist, der zwischen einen der Verbindungspunkte (01, 02) und dem Steueranschluss des dazu zugeordneten Transistors (D, C) geschaltet ist.

3. Schaltungsanordnung nach Anspruch 1 oder 2, bei der die Verstärkerschaltung zumindest einen Impulsformer und/oder Impulsgeber (I) aufweist, der zwischen einen der Verbindungspunkte (O1, O2) und den Steueranschluss des dazu zugeordneten Transistors (F, E) geschaltet ist.

4. Schaltungsanordnung nach Anspruch 2 und 3, bei der die Verstärkerschaltung zumindest einen Verstärker (V) und zumindest einen Impulsformer und/oder Impulsgeber aufweist, wobei der Verstärker (V) zwischen einen der Verbindungspunkte (01, 02) und den Steueranschluss des dazu zugeordneten vierten oder dritten Transistors (D, C) geschaltet ist und wobei der Impulsformer und/oder Impulsgeber zwischen diesen der Verbindungspunkte (01, 02) und einen weiteren, fünften oder sechsten Transistor (F bzw. E) geschaltet ist, wobei der weitere Transistor (F, E) parallel zu dem vierten bzw. dritten Transistor (D, C) geschaltet ist, der über den Verstärker (V) vom selben Verbindungspunkt (O1, O2) angesteuert wird.

5. Schaltungsanordnung nach Anspruch 3 oder 4, bei welcher der Impulsformer und/oder Impulsgeber (I) dem Verstärker (V) nachgeschaltet ist und ein verstärktes Steuersignal vom Verstärker (V) empfängt.

6. Schaltungsanordnung nach einem vorstehenden Anspruch, bei der die Verstärkerschaltung (I) einen oder mehrere Transistoren (E, F) ansteuert, welche parallel zu Transistoren (C, D) geschaltet sind, welche von dem jeweils selben Verbindungspunkt (02, O1) angesteuert werden.

7. Schaltungsanordnung nach einem vorstehenden Anspruch, bei der die Verstärkerschaltung (Y) mehrere Eingänge zum Anlegen jeweils eines Steuersignals von einem der Verbindungspunkte (01, 02) und zumindest einen, vorzugsweise mehrere Ausgänge zum Ausgeben verstärkter und/oder geformter Steuersignale zu Steuereingängen des dritten und/oder vierten und/oder weiteren Transistoren (C, D, E, F) aufweist.

8. Schaltungsanordnung nach einem vorstehenden Anspruch, bei welcher der erste und der zweite Transistor (A, B) jeweils einen Steueranschluss aufweisen zum Anlegen jeweils eines Spannungssignals aus einem Spannungssystem (1) mit niedrigerer Spannung (UDD-USS) als zwischen der Grundspannung (XUSS) und der Versorgungsspannung (XUDD).

9. Schaltungsanordnung nach einem vorstehenden Anspruch, bei der die Verstärkerschaltung zum Ausgeben eines verstärkten und/oder geformten Steuersignals ausgebildet und geschaltet ist.

10. Differenzverstärker mit einer Schaltung zum Verstärken eines Differenzsignals und mit einer Verstärkerschaltung nach einem vorstehenden Anspruch.

11. Verfahren zum Betreiben einer Phasenschieberschaltung oder eines Differenzverstärkers, wobei Steuersignale über Kreuz gekoppelter Transistoren (B, C; D, E) vor deren Anlegen an einen Steueranschluss des zugeordneten Transistors verstärkt und/oder geformt werden.

12. Verfahren Anspruch 11, bei dem die Steuersignale nur zeitlich begrenzt verstärkt und/oder geformt an den entsprechenden Steueranschluss angelegt werden.
